# EUROPEAN PATENT APPLICATION

(11) **EP 1 936 712 A1**
(43) Date of publication of application: **25.06.2008**
(21) Application number: 06026847.1
(22) Date of filing: 23.12.2006
(51) Int. Cl.: H01L 51/05

(54) **Organic field-effect transistors with polymeric gate dielectric and method for making same**

(71) Applicant: ETH Zürich, 8092 Zürich (CH)
(72) Inventor: Kalb, Wolfgang, 8001 Zürich (CH); Thomas, Mathis, 6900 Bregenz (AT)

(57) **Abstract**

A method for making an organic field-effect device (e.g. TFT or SC-FET device) is proposed, comprising the steps of (a) depositing an polymeric dielectric with a repellency to detrimental molecules from solution or from the vapor phase to form an insulating layer and (b) depositing an oligomer layer which is grown from the vapor phase, the oligomer layer being adjacent to the insulating layer in the completed device. Furthermore the correspondingly produced organic field effect devices are disclosed.

## Description

### TECHNICAL FIELD

The present invention relates to a method for making an organic field-effect device (e.g. thin-film transistor, TFT or single crystal field-effect transistor, SC-FET). Furthermore, it relates to correspondingly made organic field effect devices and their uses.

### BACKGROUND OF THE INVENTION

Field-effect mobilities in organic thin-films as high as in hydrogenated amorphous silicon (a-Si:H) have been achieved for some ten years now. The main advantage of organic semiconductors is the easy deposition by thermal evaporation or printing. Early works employed Si/SiO₂ substrates for convenience, and the device characteristics significantly improved after Lin et al. suggested to render the SiO₂ surface hydrophobic with the self assembling agent octadecyltriclorosilane (OTS) (see e.g. Y. Y. Lin, D. J. Gundlach, D. J. Nelson, and T. N. Jackson, IEEE Electron Device Lett. 18, 606 ; 1997). To fully exploit the potential of organic semiconductors, however, it is of great importance to employ easily processable (organic) gate insulators.

One of the last obstacles to be overcome for a successful commercialization of organic semiconductor transistors is gate bias stress effects. Switching the devices on for some time leads to a reduction in current at a given gate voltage readily degrading the transistor application. Gate bias stress has often been studied by applying a fixed gate voltage for an extended time, followed by a measurement of the shift of the transfer characteristic. The causes of gate bias stress effects are not yet completely identified. The effects are thought to be due to trapping and release of charge carriers on a time scale comparable to the measurement time. Such "slow" states may be permanently present or created by a gate bias induced reversible process. Mounting evidence indicates that water in the dielectric-semiconductor interface region can cause gate bias stress effects.

The following documents from the state-of-the-art are regarded as giving the general background of the present invention:
US 6,100,954 discloses general methods for manufacturing a transistor. Several gate insulators are named such as the highly hydrophobic CytopTM. The nature of the semiconductor is specified in the examples to be inorganic.
US 2006/0155040 focuses on compositions of different organic semiconductors which then form the organic semiconducting layer. Several solution-based deposition methods are disclosed for the deposition of the semiconductor composition. In an example, Cytop-107M (from Asahi Glass) is used as the gate dielectric and is deposited onto the semiconducting layer.
J. Veres et al., Chem. Mater. 16, 4543 (2004) in a review paper presents some results on organic transistors with a polymeric semiconductor and with CytopTM as the gate insulator in a top gate structure. J. Veres et al., Advanced Functional Materials 13, 199 (2003) presents results on organic transistors with a polymeric semiconductor and a fluoropolymer as the gate dielectric.
US 7,029,945 discloses a process to fabricate an organic thinfilm transistor. Both the organic insulator and the organic semiconductor are deposited from solution. As the semiconductor both oligomers and polymers are proposed. In an example the material Cytop as available from Asahi Glass is employed as the gate insulator.
US 6,946,676 discloses an organic thin film transistor comprising a polymeric layer interposed between a gate dielectric and an organic semiconductor layer. Various homopolymers, copolymers, and functional copolymers are taught for use in the polymeric layer. An integrated circuit comprising a multiplicity of thin film transistors and methods of making a thin film transistor are also provided. The organic thin film transistors exhibit improvement in one or more transistor properties.
US 2005/0224922 discloses a semiconductor device with a polymer dielectric. Polymers are used for the organic semiconductor, and these are deposited by spin-on techniques, by chemical vapour deposition and by gas phase deposition. CytopTM fluoropolymer is named as a specific example for a commercially available polymer dielectric.

### SUMMARY OF THE INVENTION

Key elements of a field-effect transistor are the gate dielectric and the active semiconductor. The deposition methods of the dielectric and the semiconductor are equally important and must suit the purpose of the application.

It is thus one object of the present invention to propose an improved method for making an organic field-effect device, in particular with a charge mobility above or equal to 10⁻⁴ cm²/Vs. In accordance with the present invention, the method comprises (inter alia) the steps of
(a) depositing an polymeric dielectric, preferably with a repellency to detrimental substances or molecules like e.g. water, from solution or from the vapor phase to form an insulating layer and
(b) depositing an (organic) oligomer layer which is grown from the vapor phase, the oligomer layer being adjacent to the insulating layer in the completed device.

It can be shown as given further below that these specific process steps lead to unexpected beneficial properties of correspondingly made organic field effect transistors, e.g. leading to organic field effect transistors with unprecedented resistance against gate bias stress and with a remarkable electrical breakdown strength. The correspondingly made single crystal devices have no current hysteresis, and extended bias stress only leads to marginal changes in the transfer characteristics.

According to a specific aspect of the invention, the polymeric dielectric is an amorphous fluororpolymer, preferably an amorphous perfluororpolymer resin, preferentially with a permittivity (εᵢ) in the range of 1.2 - 4, preferably in the range of 1.8-2.5, most preferentially with a permittivity in the range of 2.1-2.2. The polymeric dielectric can be an amorphous fluoropolymer with a high water repellency and/or wherein the polymeric dielectric is transparent or translucent. Particularly good results are achieved if the polymeric dielectric is chosen to be Cytop, e.g. Cytop CTL-809M as available from Asahi Glass, JP, and specifically good results can be achieved if this is system is deposited from solution, e.g. in a spin coating process, onto a substrate, e.g. an ITO-coated glass substrate..

According to a further aspect of the invention, the oligomer is a hole transporting oligomer, an electron transporting oligomer or an electron and hole transporting oligomer. The oligomer can be selected from the group consisting of pentacene, tetracene, anthracene, naphthalene, oligothiophenes such as alpha-sexithiophene alpha-quinquethiophene or alpha-quarterthiophene, pyrene, perylene, rubrene, coronene, perylene tetracarboxylic diimide, perylene tetracarboxylic dianhydride, oligoacene of naphthalene, phthalocyanine and/or fluorophthalocyanine which optionally include a metal such as Cu, Ni, Co, perylene tetracarboxylic acid dianhydride, perylene tetracarboxylic diimide, naphthalene tetracarboxylic diimide, N,N'-ditridecylperylene-3,4,9,10-tetracarboxylic diimide (PTCDIC13H27), fullerenes such as C60, C70 or C80, chrysene, p-quarterphenyl, p-quinquephenyl, p-sexiphenyl or naphthalene tetracarboxylic acid dianhydride as well as mixtures, blends and/or derivatives thereof, wherein preferably pentacene, rubrene, derivatives or mixtures thereof are used

According to a further aspect the oligomer is evaporated and deposited in vacuo, or alternatively in a gas such as argon, helium, nitrogen and/or oxygen or mixtures thereof (e.g. air).

The oligomeric semiconductor layer and the insulating layer can be made separately and the layers subsequently combined or joined in a further step of the fabrication process.

The organic field-effect device can have a charge mobility above than or equal to 10⁻³ cm²/Vs, preferably above than or equal to 10⁻² cm²/Vs, even more preferably above than or equal to 10⁻¹ cm²/Vs.

The surface roughness and surface morphology of the insulating layer seems, especially if the oligomeric semiconductor layer is deposited onto a prepared layer of insulating material, i.e. of the polymeric dielectric, or if the insulating material, i.e. the polymeric dielectric is deposited onto an oligomeric semiconductor layer, to be an important factor for obtaining the above values. According to present knowledge it seems beneficial if the surface roughness is not larger than the average molecular size of the oligomers deposited or put adjacent to the insulating layer.

According to a further embodiment of the above method, the deposition of the polymeric dielectric thus is carried out to lead to a surface of the insulating layer with an RMS-roughness as calculated from AFM-images in the range of below or equal to 2 nm, preferably below of or equal to 1 nm, and even more preferably in the range of below or equal to 0.8 nm.

The organic field-effect device can have an on-off current ratio above than or equal to 10², preferably above than or equal to 10³ even more preferably above than or equal to 10⁴, wherein the off-current is defined as the current at zero gate bias.

The specific chemical nature of the insulator and its surface seems to be an important factor for obtaining a low off-current. The low off-current contributes to achieving the above values for the on-off current ratio. A shifted onset voltage can, depending on the sign of the shift and the sign of the charge carriers, lead to a high current at zero applied gate bias thus degrading the on-off current ratio. According to present knowledge, such shifts are due to an exchange of charge between the semiconductor and specific chemical entities of the insulator including its surface which then becomes permanently trapped.

In terms of the above-mentioned repellency of the insulating layer this can be characterised by the static water contact angle. According to another embodiment and therefore the deposition of the polymeric dielectric leads to a surface of the insulating layer with a static water contact angle above than or equal to 105°, preferably above than or equal to 110°.

According to a further embodiment, in a first step the polymeric dielectric is deposited to form an insulating layer, and in a second step the oligomer layer is grown from the vapor phase directly onto this insulating layer. In the alternative, in a first step the oligomer layer is grown from the vapor phase and in a second step the polymeric dielectric is deposited onto the oligomer layer to form an insulating layer.

The present invention furthermore relates to an organic field effect device, in particular with a charge mobility above or equal to 10⁻⁴ cm²/Vs, comprising at least one layer structure obtainable or obtained by a method as given above.

The suitable thickness of the layer depends on the voltage with which the device is to be driven. So for small voltages up to 10 V for example thicknesses below 100nm, preferably below 50nm can be possible and useful. For large voltages the layer may even have a thickness above than or equal to one micrometer. These values are however given for a situation where there is only one single insulation layer. It is also possible to have several (different) insulation layers.

According to a specific aspect of the present invention, the organic field effect device has a bottom gate structure, where the oligomeric semiconductor is deposited onto the organic gate insulator and/or it has a top gate structure, where the organic insulator is deposited onto the oligomeric semiconductor layer. More specifically, the organic field effect device can be a TFT or SC-FET device. The gate insulator can consist of the polymeric dielectric only or it can consist of the polymeric dielectric layer adjacent to the oligomeric semiconducting layer and one or more layers of any other organic or inorganic dielectric.

Further embodiments of the present invention are outlined in the dependent claims.

### SHORT DESCRIPTION OF THE FIGURES

In the accompanying drawings properties of preferred embodiments of the invention are shown in which:

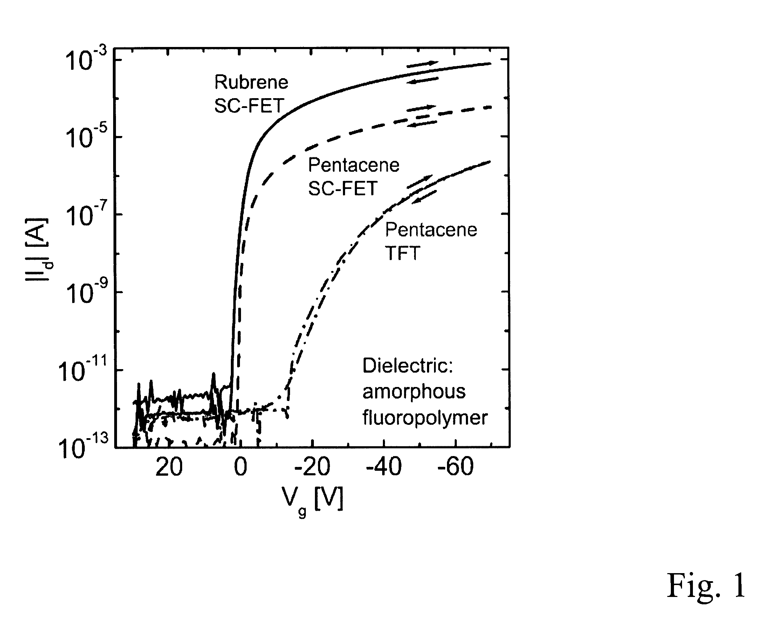

- Figure 1: shows the transfer characteristics in saturation (Vd = -80V) for a rubrene SC-FET, a pentacene SC-FET and a pentacene TFT, wherein forward and reverse sweeps are shown but are indistinguishable over the entire operating range for the SC-FETs and wherein the TFT shows only a small current hysteresis near the onset;

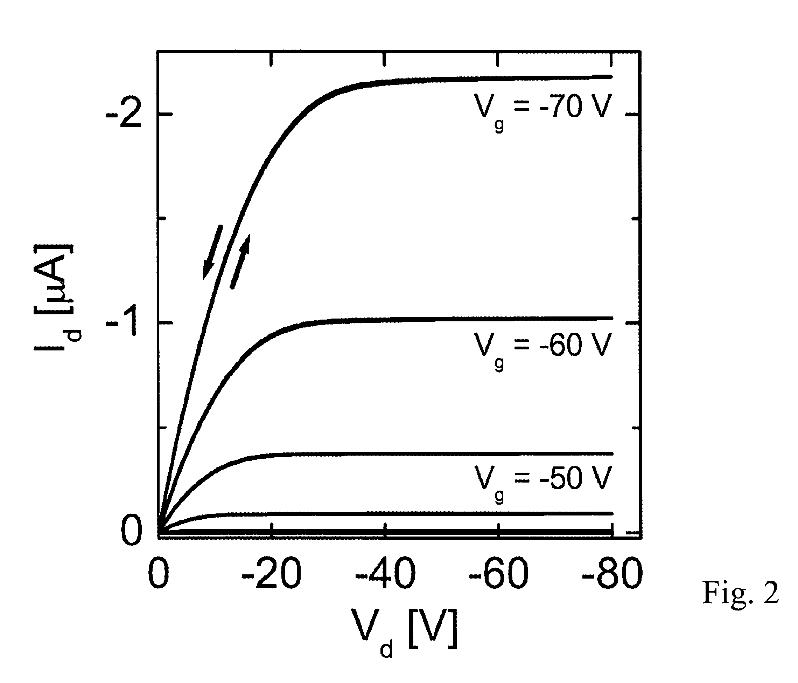

- Figure 2: shows the output characteristic of the pentacene TFT revealing the ideal thin-film transistor operation; and

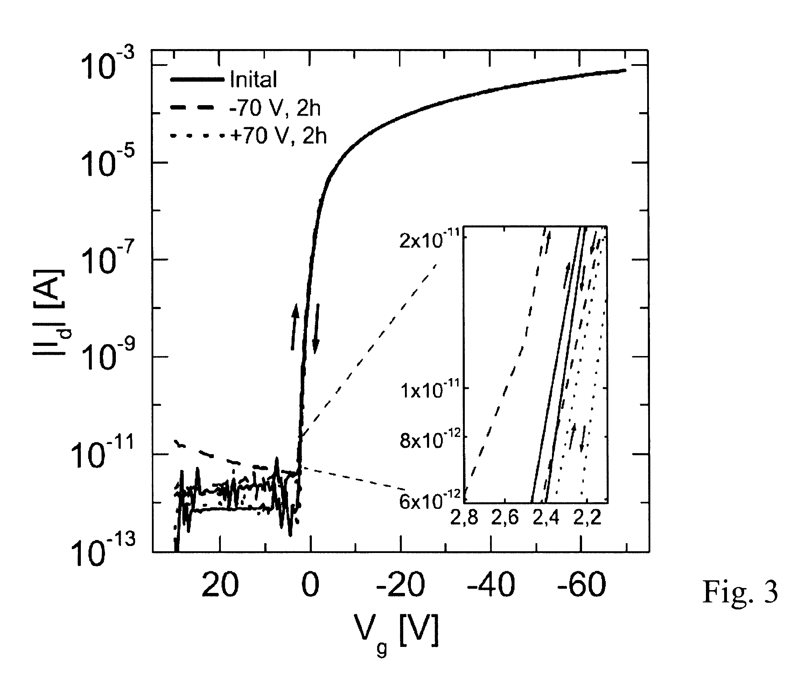

- Figure 3: shows that the rubrene single crystal device is highly stable against gate bias stress, wherein the main panel shows the transfer characteristic measured at V_{d} = -80V prior to the stress sequence (full line), after two hours of gate bias stress at V_{g} = -70V (dashed line) and after subsequent gate bias stress at V_{g} = +70V for two hours (dotted line), and wherein the graph includes the forward and reverse sweep in all three cases. The inset shows the drain currents close to the onset voltage.

### DETAILED DESCRIPTION OF THE PREFERRED EMBODIMENTS

The present disclosure pertains to a process to fabricate an organic field-effect device comprising (a) depositing an polymeric dielectric layer from solution or from the vapor phase and (b) depositing an oligomeric semiconductor from the vapor phase. The polymeric dielectric has a very high repellency of molecules, or generally chemical entities, which are detrimental to the charge transport in oligomeric semiconductors. The process is such that in the field-effect device, the polymeric dielectric layer is adjacent to the oligomeric semiconducting layer and constitutes all or part of the gate insulator.

We have fabricated organic field-effect transistors with an organic gate dielectric (Cytop CTL-809M), that was deposited from solution by spin-coating. The amorphous fluoropolymer has a very high water repellency and excellent insulating properties. The active semiconducting layer of the devices consisted of pentacene or rubrene (oligomeric organic semiconductors) and the layers were grown from the vapor phase. The combination of the amorphous fluoropolymer with the semiconductors pentacene or rubrene leads to organic field-effect transistors with unprecedented resistance against gate bias stress. This stability of electrical properties is a key issue for a successful commercialisation of organic field-effect transistors in low-cost, large area, flexible electronics. Our fabrication process consists of low-cost, large area compatible deposition methods and is suitable for plastic substrates.

It is presently believed but not fully verified yet that the high electrical stability of the transistors is due to the very high water repellence of the CytopTM insulator since water is believed to be detrimental for the charge transport in organic semiconductors.

So herein novel combinations of small molecule organic semiconductors in which an oligomer layer is grown from the vapor phase and an organic spin-on dielectric are proposed that yield field-effect transistors with exceptionally high quality characteristics and stability. The transistors have a bottom gate structure with an amorphous fluoropolymer (CytopTM) as gate dielectric. This fluoropolymer is highly transparent, in contrast to ordinary teflon, and its relative permittivity is εᵢ = 2.1-2.2. We demonstrate this favorable material in combination with two small molecule semiconductors: rubrene and pentacene, other small molecule semiconductors however also being possible. The device stability was evaluated by applying a gate bias for extended periods of time.

The devices were fabricated as follows:
Insulation layer:
   ITO coated glass slides served as substrate and gate electrode. For the insulating layer, CytopTM from Asahi Glass, Japan was spin-coated onto the ITO and dried for one hour at 90°C. The insulator was characterized by measuring the capacitance, leakage current and electrical breakdown. The thickness of the insulating layer was determined for each sample with a surface step profiler. The films are 430 to 600 nm thick, which gives a gate capacitance of 4.4 to 3.2 nF/cm². Leakage current and electrical breakdown measurements on a typical sample (457 ± 10 nm thick) show current levels below 1 µA up to 450 V, where the dielectric breaks down. This is remarkably good for an organic insulator and is better than the thermally grown SiO₂ that we have in use.
   The surface morphology of the insulator was investigated by AFM. The RMS roughness calculated from several AFM images of size 4 µm x 4 µm is 0.6 nm. Static water contact angles which are a measure for the water repellency were measured with a homebuilt device and are about 115°.
   Specifically, an ITO-coated glass slide was cleaned and coated with the amorphous fluoropolymer Cytop CTL-809M by spin-coating. For this process, a mixture of Cytop CTL-809M and the solvent CT-Solv.180 (commercially available from Asahi Glass, Japan) was applied onto the ITO. The amorphous fluoropolymer was dried on a hotplate at 90 °C for one hour. The thickness of the insulating layer was measured with a surface step profiler giving a thickness of 590 to 600 nm.
Rubrene and pentacene single crystal field-effect transistor:
   Rubrene and pentacene single crystal field-effect transistors (SC-FETs) were made by evaporating 30 nm thick gold source and drain contacts onto the fluoropolymer in high vacuum. The single crystals were grown separately by physical vapor transport with argon as carrier gas. The crystals were placed on the prefabricated substrates in air.
   Specifically for rubrene, this was carried out as follows: 30 nm thick gold electrodes with an interelectrode spacing of 50 µm were evaporated onto the CytopTM in high vacuum. A rubrene single crystalline layer was grown separately by sublimation and deposition of rubrene in a stream of argon. The transistor was completed by placing the single crystalline layer onto the prefabricated substrate. The effective width of the crystal was 850 µm.
Pentacene thin-film transistor:
   Pentacene thin-film transistors (TFTs) were fabricated by evaporating a 50 nm thick pentacene film through a shadow mask onto the CytopTM in high vacuum (base pressure 5*10⁻⁸ mbar) while keeping the substrate at room temperature. The thin-film devices were completed by evaporating gold electrodes through a shadow mask onto the pentacene thin-film in the same chamber resulting in a thin-film transistor test structure with a channel length of 100 µm and a channel width of 500 µm.
Results:
   All device characteristics were measured in a dry He atmosphere (H₂O, O₂ < 0.5 ppm) using a HP 4155A semiconductor parameter analyzer.

The excellent performance of the devices is shown in Fig. 1. The transfer characteristics from a rubrene SC-FET, a pentacene SC-FET and a pentacene TFT, measured in saturation with V_{d} = -80V, are given for the forward and the reverse sweep. Most remarkable is the absence of any hysteresis for the SC-FETs. A further mark of the high quality of these devices is the steep subthreshold swing, 0.50V/dec for the rubrene SC-FET and 0.29V/dec for pentacene SC-FET. This gives normalized subthreshold swings of respectively 1.6 nFV/(dec cm²) and 1.3 nFV/(dec cm²), which are among the best values for an organic transistor obtained to date. Higher subthreshold swings and a large current hysteresis are measured when we place nominally identical crystals on OTS surface-treated SiO₂. The saturation field-effect mobilities from the crystals (5.7 cm²/Vs and 1.4 cm²/Vs) are comparable to pentacene or rubrene SC-FETs with other dielectrics such as OTS-treated SiO₂. The thin-film transistor shows a notable hysteresis in the transfer characteristic close to the onset voltage. The hysteresis is much less apparent on a linear scale, i.e when the transistor is switched on completely. In any case, the hysteresis is small compared to pentacene thin-film devices on OTS-treated SiO₂ that were measured in the same inert atmosphere.

Fig. 2 shows the output characteristic of the pentacene TFT, revealing the ideal thin-film transistor behavior, with a saturation field-effect mobility of 0.26 cm²/Vs. The transistor shows no current hysteresis in the fully on state, i.e. a high electrical stability.

Desirable as well is the very small (only slightly positive) onset voltage of the two single crystal devices (+3.3V for rubrene and +1.0V for pentacene). The onset is negative in the case of the thin-film transistor, i.e. -13V (Fig. 1). A large positive onset voltage in the case of a hole transporting organic semiconductor would usually be undesirable since it would lead to a high current at zero applied gate bias thus degrading the switching property of the transistor.

The advantages of the material combinations become striking in gate bias stress studies. We have applied a fixed gate voltage to the three devices in Fig. 1 for a prolonged time. After the initial transfer characteristic measurement, a gate bias of V_{g} = -70V was applied for two hours. After a two hour relaxation period, a gate bias of V_{g} = +70V was applied. Both the negative and the positive bias stress period were shortly interrupted (for 70 s) after 10, 20, 30 and 60 minutes in order to measure a transfer characteristic. Bias stress experiments were carried out in the dark.

For the rubrene SC-FET, Fig. 3 shows the initial characteristic, the characteristic measured after 2 hours of negative bias and after 2 hours of positive bias. The device is hardly influenced by the long application of a gate bias. There are only marginal changes in the transfer characteristic. After negative stress, there is a very small shift of the onset voltage to more positive voltages, accompanied by a small increase in current hysteresis and a small decrease in on-current. For the pentacene SC-FET, the observations are similar. When compared to the rubrene device, the shift of the onset voltage due to bias stress is even smaller but the decrease in on-current is somewhat more pronounced. In contrast, in similar experiments with single crystals of rubrene or pentacene on OTS-treated SiO₂, large shifts of the transfer characteristics are observed. For the pentacene TFT, a gate voltage of Vg = -70V applied for two hours leads to a rigid shift of the curve by -5.2V to more negative voltages.

The main panel of Figure 3 shows the initial transfer characteristic, the transfer characteristic measured after 2 hours of negative gate bias and after 2 hours of positive gate bias. The graph includes the forward and reverse sweep in all three cases and there is no current hysteresis. The changes in the characteristics due to the prolonged application of a gate voltage are marginal. The device is very stable against gate bias stress.

The measurements on the SC-FETs show that it is possible to produce highly stable transistors with small molecule organic semiconductors combined with an appropriate gate dielectric. The bias stress effects often observed in organic transistors are the result of combining the organic semiconductor with an inappropriate gate dielectric. Inappropriate dielectrics have surface states that lead to a significant charge carrier trapping in longlived states. In particular the surface of the amorphous fluoropolymer on the contrary seems to have a highly desirable quality: essentially no electrically active trap states form in combination with the organic semiconductors. Bias stress effects are marginal, and thus long-lived states for holes seem to be (almost) non-existent at the insulator surface. The steep subthreshold swing from the single crystal devices suggests that "fast" surface states are negligible as well. It is remarkable that the insulator works very well with two different semiconductors, i.e. rubrene and pentacene and extension to further systems is thus documented. This may indicate that the absence of surface states is due to the absence (or low density) of a specific chemical species on the insulator surface which is detrimental to hole transport in organic semiconductors. Water possibly is such a generally detrimental molecule.

In addition, we do not observe a large positive onset voltage which can occur in the case of fluorine containing molecules at the insulator-semiconductor interface of an organic semiconductor transistor. Shifts of the onset voltage are thought to be due to a permanent charge transfer to chemical entities of the insulator and its surface. We can conclude that chemical entities which are capable of permanently accepting charge and shifting the onset voltage are (almost) absent on the surface or in bulk of the CytopTM fluoropolymer.

In conclusion, the above highlights the generically high performance and high stability of small molecule organic semiconductors when combined with a suitable gate dielectric. FETs with rubrene and pentacene (and other oligomeric semiconductor systems) in combination with a fluoropolymer show excellent electrical characteristics, and they are hardly affected by long-term gate bias stress. It seems that there is no conceptual limitation for the stability of organic semiconductors.

## Claims

1. Method for making an organic field-effect device with a charge mobility above or equal to 10⁻⁴ cm²/Vs comprising the steps of
(a) depositing an polymeric dielectric, preferably with a repellency to detrimental substances or molecules, from solution or from the vapor phase to form an insulating layer and
(b) depositing an oligomer layer which is grown from the vapor phase, the oligomer layer being adjacent to the insulating layer in the completed device.

2. Method according to claim 1, wherein the polymeric dielectric is an amorphous fluororpolymer, preferably an amorphous perfluororpolymer resin, preferentially with a permittivity in the range of 1.2 - 4, preferably in the range of 1.8-2.5, most preferentially with a permittivity in the range of 2.1-2.2.

3. Method according to any of the preceding claims, wherein the polymeric dielectric is an amorphous fluoropolymer with a high water repellency and/or wherein the polymeric dielectric is transparent or translucent.

4. Method according to any of the preceding claims, wherein the polymeric dielectric is Cytop, preferably Cytop CTL-809M.

5. Method according to any of the preceding claims, wherein the polymeric dielectric is applied as a solution, for example in a spin coating process, onto a substrate, for example onto an ITO-coated glass substrate.

6. Method according to any of the preceding claims, wherein the oligomer is a hole transporting oligomer, an electron transporting oligomer or an electron and hole transporting oligomer.

7. Method according to claim 6, wherein the oligomer is selected from the group consisting of pentacene, tetracene, anthracene, naphthalene, oligothiophenes such as alspha-sexithiophene, alpha-quinquethiophene, alpha-quarterthiophene, pyrene, perylene, rubrene, coronene, perylene tetracarboxylic diimide, perylene tetracarboxylic dianhydride, phthalocyanine and/or fluorophthalocyanine which optionally include a metal such as Cu, Ni, Co, perylene tetracarboxylic acid dianhydride, perylene tetracarboxylic diimide, naphthalene tetracarboxylic diimide, N,N'-ditridecylperylene-3,4,9,10-tetracarboxylic diimide (PTCDIC13H27), fullerenes such as C60, C70 and/or C80, chrysene, p-quarterphenyl, p-quinquephenyl, p-sexiphenyl or naphthalene tetracarboxylic acid dianhydride as well as mixtures, blends and/or derivatives thereof, wherein preferably pentacene, rubrene, derivatives or mixtures thereof are used.

8. Method according to any of the preceding claims, wherein the oligomer is evaporated and deposited in vacuum, or alternatively in a gas such as argon heluim, nitrogen and/or oxygen as well as mixtures thereof.

9. Method according to any of the preceding claims, wherein the oligomeric semiconductor layer and the insulating layer are made separately and the layers subsequently combined in further step of the fabrication process.

10. Method according to any of the preceding claims, wherein the organic field effect device have a charge mobility above than or equal to 10⁻³ cm²/Vs, preferably above than or equal to 10⁻² cm²/Vs, even more preferably above than or equal to 10⁻¹ cm²/Vs.

11. Method according to any of the preceding claims, wherein deposition of the polymeric dielectric leads to a surface of the insulating layer with an RMS-roughness as calculated from AFM-images is in the range of below or equal to 2 nm, preferably below of or equal to 1nm, preferentially below or equal to 0.8nm, and even more preferably in the range of 0.1-0.8 nm.

12. Method according to any of the preceding claims, wherein deposition of the polymeric dielectric leads to a surface of the insulating layer with a static water contact angle above than or equal to 105°, preferably above than or equal to 110°.

13. Method according to any of the preceding claims, wherein in a first step the polymeric dielectric is deposited to form an insulating layer, and wherein in a second step the oligomer layer is grown from the vapor phase directly onto this insulating layer, or wherein in a first step the oligomer layer is grown from the vapor phase and in a second step the polymeric dielectric is deposited onto the oligomer layer to form an insulating layer.

14. Organic field effect device with a charge mobility above or equal to 10⁻⁴ cm²/Vs comprising a layer structure obtainable or obtained by a method according to any of the preceding claims.

15. Organic field effect device according to claim 14, wherein the polymeric dielectric layer has a thickness depending on the applied voltage and depending on whether the polymeric dielectric constitutes all of the gate dielectric or is a layer interposed between another dielectric and the organic semiconducting layer, for example below 700nm, preferably in the range of 10-500nm.

16. Organic field effect device according to any of claims 14 or 15, wherein it has a bottom gate structure, where the oligomeric semiconductor is deposited onto the polymeric gate insulator and/or wherein it has a top gate structure, where the polymeric insulator is deposited onto the oligomeric semiconductor layer.

17. Organic field effect device according to any of claims 14-16, wherein it is a TFT or SC-FET device.

18. Organic field effect device according to any of claims 14-17, wherein the gate insulator consists of the polymeric dielectric only or consists of the polymeric dielectric layer adjacent to the oligomeric semiconducting layer and one or more layers of any other organic or inorganic dielectric.

19. Organic field effect device according to any of claims 14-18, wherein it has an on-off current ratio above than or equal to 10², preferably above than or equal to 10³, even more preferably above than or equal to 10⁴.
